# EUROPÄISCHE PATENTSCHRIFT

(11) **EP 3 819 988 B1**
(45) Veröffentlichungstag und Bekanntmachung des Hinweises auf die Patenterteilung: **23.04.2025**
(21) Anmeldenummer: 20201049.2
(22) Anmeldetag: 09.10.2020
(51) Int. Cl.: H01R 12/52, H01R 12/62, H01R 12/69, H05K 3/36, H01R 43/20

(54) **ELEKTRISCH LEITENDE VERBINDUNG VON LEITERPLATTEN**
ELECTRICALLY CONDUCTIVE CONNECTION OF PRINTED CIRCUIT BOARDS
RACCORDEMENT ÉLECTROCONDUCTEUR DE CARTES DE CIRCUIT IMPRIMÉ

(30) Priorität: 05.11.2019 DE 102019129719
(43) Veröffentlichungstag der Anmeldung: 12.05.2021
(73) Patentinhaber: Marelli Germany GmbH, 72762 Reutlingen (DE)
(72) Erfinder: Harder, Anna, 72768 Reutlingen (DE)
(74) Vertreter: DREISS Patentanwälte PartG mbB

(56) Entgegenhaltungen:
- EP-A2- 0 664 576
- EP-A2- 2 107 642
- DE-A1- 102007 008 109
- DE-A1- 102016 218 788
- DE-A1- 2 624 330
- DE-T2- 60 209 408
- DE-U1- 202007 002 940
- JP-A- H08 213 068
- US-A- 3 980 367

## Beschreibung

Die Erfindung betrifft eine elektrisch leitende Kontaktverbindung zwischen einer ersten und einer zweiten Leiterplatte gemäß dem Oberbegriff des Anspruchs 1.

Ferner betrifft die Erfindung ein Verfahren zum Herstellen einer elektrisch leitenden Kontaktverbindung zwischen einer ersten Leiterplatte und einer zweiten Leiterplatte gemäß dem Oberbegriff des Anspruchs 3.

Elektrisch leitende Kontaktverbindungen zwischen Bauteilen, beispielsweise Leiterplatten, sind aus dem Stand der Technik bekannt. Aus der DE 41 32 995 A1 ist es beispielsweise bekannt Kontakte einer starren Leiterplatte mit Kontakten einer flexiblen Leiterplatte zu verlöten. Ferner ist es beispielsweise bekannt zwei Leiterplatten, insbesondere einer starre und eine flexible Leiterplatte, über sogenannte Steckverbinderleisten und Leiterplattenbuchsen, Stift- oder Buchsenleisten, die auf den Leiterplatten montiert sind, miteinander zu verbinden. Ferner sind aus der US 3,980,367 A, JP H08 213068 A und der EP 2 107 642 A2 Verbindungen mit den Merkmalen des Oberbegriffs des Anspruchs 1 bekannt, bei denen ein Verbindungselement zunächst gleichzeitig durch Öffnungen in zwei oder mehr Leiterplatten hindurchgeführt wird und anschließend durch Umformen des Verbindungselements eine Verbindung hergestellt wird.

EP 0 664 576 A2 offenbart eine Verbindungselement, das zunächst durch Umformen mit einer ersten Leiterplatte und anschließend durch Einpressen mit einer weiteren Leiterplatte verbunden wird.

Aufgabe der vorliegenden Erfindung ist es eine gegenüber dem Stand der Technik kostengünstigere, mit einem geringeren Aufwand herstellbare elektrisch leitende Kontaktverbindung und ein Verfahren zum Herstellen der elektrisch leitenden Kontaktverbindung anzugeben.

Erfindungsgemäß wird vorgeschlagen, dass die erste Leiterplatte im Bereich der Kontaktverbindung einen Anschlussstift umfasst und die zweite Leiterplatte im Bereich der Kontaktverbindung eine Durchstecköffnung umfasst, wobei der Anschlussstift der ersten Leiterplatte wenigstens teilweise aus einem elektrisch leitfähigen Material ausgebildet ist und durch die Durchstecköffnung der zweiten Leiterplatte hindurch gesteckt ist, wobei der Anschlussstift in einem durch die Durchstecköffnung der zweiten Leiterplatte über die zweite Leiterplatte herausragenden Abschnitt durch einen Umformvorgang, insbesondere einen Biegevorgang oder einen Nietvorgang, derart umgeformt ist, dass zwischen der ersten und der zweiten Leiterplatte eine formschlüssige Verbindung ausgebildet ist.

Die erfindungsgemäße Kontaktverbindung ist, ohne einen weiteren Lötvorgang zu erfordern, herstellbar. Im Vergleich zu einer Steckverbindung erfordert die erfindungsgemäße Kontaktverbindung wenig Materialaufwand.

Der Anschlussstift umfasst insbesondere eine zylindrische Form und ist wenigstens in einem durch die Durchstecköffnung der zweiten Leiterplatte, über die zweite Leiterplatte herausragenden, Abschnitt plastisch verformbar.

Der Anschlussstift ist beispielsweise aus Metall und/oder einer Legierung und/oder teilweise aus Kunststoff in Kombination mit einem elektrisch leitfähigen Material hergestellt.

Der Anschlussstift ist in dem durch die Durchstecköffnung der zweiten Leiterplatte, über die zweite Leiterplatte herausragenden, Abschnitt, unter Krafteinwirkung mittels einem geeigneten Werkzeug, derart umgeformt worden, dass der umgeformte Abschnitt die zweite Leiterplatte teilweise überragend gegen die erste Leiterplatte hält.

Vorteilhafterweise umfasst eine Innenwandung der Durchstecköffnung der zweiten Leiterplatte ein elektrisch leitfähiges Material. Der, durch die Durchtrittsöffnung der zweiten Leiterplatte, hindurchgesteckte Anschlussstift der ersten Leiterplatte kontaktiert die Innenwandung zumindest teilweise, vorzugsweise vollumfänglich, so dass dadurch eine elektrisch leitende Verbindung ausgebildet ist.

Der Anschlussstift ist mit der ersten Leiterplatte mittels eines Pin-in-Paste-Lötverfahrens, verbunden. Der Anschlussstift ist durch eine Öffnung, ein sogenanntes Bestückungsloch, in der ersten Leiterplatte geführt und mit der ersten Leiterplatte verlötet. Beispielsweise ist der Anschlussstift auf einer Rückseite der ersten Leiterplatte oder im Falle des Pin-in-Paste-Lötverfahrens in der Öffnung mit der ersten Leiterplatte verlötet. Beim Pin-in-Paste-Lötverfahren wird Lotpaste in die Öffnung gedruckt und anschließend der Anschlussstift hindurchgesteckt. Beim Aufschmelzen der Lotpaste zieht sich das flüssige Lot in die Öffnung zurück und bildet die Lötverbindung aus. Ebenfalls wäre es denkbar, dass der Anschlussstift in einem die erste Leiterplatte, auf der Rückseite der ersten Leiterplatte, überragenden Abschnitt einen vorgefertigten Setzkopf umfasst, so dass die Nietverbindung durch Umformen des über die zweite Leiterplatte herausragenden, Abschnitt geschlossen wird.

Alternativ ist der Anschlussstift mit der ersten Leiterplatte mittels eines SMT-, Surface-Mounting-Technologie, Lötverfahrens, verbunden. Der Anschlussstift ist dann mittels lötfähiger Anschlussflächen direkt auf die erste Leiterplatte gelötet.

Die erste Leiterplatte ist eine starre Leiterplatte und die zweite Leiterplatte ist eine flexible Leiterplatte. Die erste Leiterplatte umfasst beispielsweise als nichtleitendes Trägermaterial eine mit Epoxidharz getränkte Glasfasermatte, auch unter der Materialkennung FR4 bekannt. Die zweite Leiterplatte ist beispielsweise eine, insbesondere dünne, Leiterplatte auf Basis von Polyimid-Folien. Solche Leiterplatten können vorteilhafterweise platzsparend, insbesondere durch Falten in engsten Strukturen, beispielsweise in Beleuchtungseinrichtungen, und/oder zum Verbinden von zwei starren Leiterplatten, beispielsweise in Beleuchtungseinrichtungen, verwendet werden.

Weitere bevorzugte Ausführungsformen beziehen sich auf ein Verfahren zum Herstellen einer elektrisch leitenden Kontaktverbindung zwischen einer ersten Leiterplatte und einer zweiten Leiterplatte, wobei die erste Leiterplatte im Bereich der Kontaktverbindung einen Anschlussstift umfasst und die zweite Leiterpatte im Bereich der Kontaktverbindung eine Durchstecköffnung umfasst, wobei der Anschlussstift der ersten Leiterplatte wenigstens teilweise aus einem elektrisch leitfähigen Material ausgebildet ist, dadurch gekennzeichnet, dass der Anschlussstift der ersten Leiterplatte durch die Durchstecköffnung der zweiten Leiterplatte hindurch gesteckt wird, und anschließend ein durch die Durchstecköffnung der zweiten Leiterplatte über die zweite Leiterplatte herausragender Abschnitt des Anschlussstifts in einem Umformvorgang, insbesondere einem Biegevorgang oder einem Nietvorgang, derart umgeformt wird, dass zwischen der ersten und der zweiten Leiterplatte eine formschlüssige Verbindung ausgebildet wird.

Der Anschlussstift wird in dem Umformvorgang in dem durch die Durchstecköffnung der zweiten Leiterplatte, über die zweite Leiterplatte herausragenden, Abschnitt, unter Krafteinwirkung mittels einem geeigneten Werkzeug, derart umgeformt, dass der umgeformte Abschnitt anschließend die zweite Leiterplatte teilweise überragend gegen die erste Leiterplatte hält.

Das Umformen umfasst beispielsweise ein sogenanntes Anstauchen des Anschlussstiftes und/oder das Vorformen eines Nietkopfs, insbesondere durch kreisende Schläge mit dem Kugelkopfhammer, und/oder das endgültige Formen des Nietkopfs, insbesondere mittels eines Nietkopfsetzers.

Der Anschlussstift wird in einem vorhergehenden Schritt mit der ersten Leiterplatte mittels eines Pin-in-Paste Lötverfahrens, verbunden.

Alternativ wird der Anschlussstift in einem vorhergehenden Schritt mit der ersten Leiterplattem mittels eines SMT-, Surface-Mounting-Technologie-, Lötverfahren, verbunden. Ausführungsbeispiele der Erfindung sind in den Zeichnungen dargestellt und werden in der nachfolgenden Beschreibung näher erläutert. Dabei bezeichnen gleiche Bezugszeichen in verschiedenen Figuren jeweils gleiche oder zumindest ihrer Funktion nach vergleichbare Elemente. Es zeigen, jeweils in schematischer Form:
- Fig. 1: eine erfindungsgemäße elektrisch leitende Kontaktverbindung gemäß einer ersten bevorzugten Ausführungsform;
- Fig. 2: eine erfindungsgemäße elektrisch leitende Kontaktverbindung gemäß einer weiteren bevorzugten Ausführungsform, und
- Fig. 3: mit erfindungsgemäßen Kontaktverbindungen miteinander verbundene Leiterplatten.

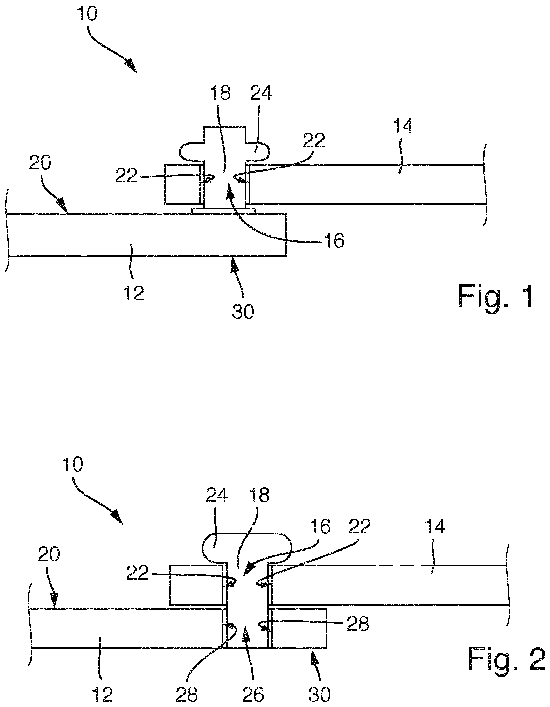

Fig. 1 zeigt eine erfindungsgemäße elektrisch leitende Kontaktverbindung gemäß einer ersten bevorzugten Ausführungsform in einer Schnittansicht, die in ihrer Gesamtheit mit dem Bezugszeichen 10 bezeichnet ist. Die Kontaktverbindung 10 verbindet eine erste Leiterplatte 12 mit einer zweiten Leiterplatte 14. Die zweite Leiterplatte 14 umfasst eine Durchstecköffnung 16 und die erste Leiterpatte 12 umfasst einen Anschlussstift 18, der durch die Durchstecköffnung 16 der zweiten Leiterplatte 14 hindurch gesteckt ist.

Der Anschlussstift 18 ist wenigstens teilweise aus einem elektrisch leitfähigen Material ausgebildet. Gemäß der in Figur 1 dargestellten Ausführungsform ist der Anschlussstift 18 auf einer Oberfläche 20 der ersten Leiterplatte 12 montiert. Erfindungsgemäß ist der Anschlussstift 18 mittels eines SMT-, Surface-Mounting-Technologie, Lötverfahrens, mit der Oberfläche 20 der ersten Leiterplatte 12 verbunden.

Eine Innenwandung 22 der Durchstecköffnung 16 der zweiten Leiterplatte 14 umfasst ein elektrisch leitfähiges Material. Der Anschlussstift 18 kontaktiert die Innenwandung 22 zumindest teilweise, vorzugsweise vollumfänglich, so dass dadurch eine elektrisch leitende Verbindung ausgebildet ist, zwischen der ersten Leiterplatte 12 und der zweiten Leiterplatte 14 ausgebildet ist.

Der Anschlussstift 18 ist in einem durch die Durchstecköffnung 16 der zweiten Leiterplatte 14 über die zweite Leiterplatte 14 herausragenden Abschnitt 24 durch einen Umformvorgang, insbesondere einen Biegevorgang oder einen Nietvorgang, derart umgeformt, dass zwischen der ersten und der zweiten Leiterplatte 12, 14 eine formschlüssige Verbindung ausgebildet ist. Der umgeformte Abschnitt 24 hält die zweite Leiterplatte 14 teilweise überragend gegen die erste Leiterplatte 12.

Das Umformen erfolgt unter Krafteinwirkung mittels einem geeigneten Werkzeug. Das Umformen umfasst beispielsweise ein sogenanntes Anstauchen des Anschlussstiftes 18 und/oder das Vorformen der Abschnitts 24 in Form eines Nietkopfs, insbesondere durch kreisende Schläge mit dem Kugelkopfhammer, und/oder das endgültige Formen des Abschnitts 24 in Form eines Nietkopfs, insbesondere mittels eines Nietkopfsetzers.

Figur 2 zeigt die Kontaktverbindung 10 gemäß einer weiteren Ausführungsform in einer Schnittansicht. Der Anschlussstift 18 der ersten Leiterplatte ist mit der ersten Leiterplatte 12 mittels Durchkontaktierung verbunden.

Die erste Leiterplatte 12 umfasst dazu eine Öffnung 26, ein sogenanntes Bestückungsloch. Der Anschlussstift 18 ist durch die Öffnung 26 der ersten Leiterplatte 12 durchgeführt und mit der ersten Leiterplatte 12 verlötet. Gemäß der Erfindung ist der Anschlussstift 18 mittels eines Pin-in-Paste-Lötverfahrens in der Öffnung 26 mit der ersten Leiterplatte 12 verlötet. Dazu wird zunächst eine Lotpaste in die Öffnung 26 gedruckt und anschließend der Anschlussstift 18 hindurchgesteckt. Beim Aufschmelzen der Lotpaste zieht sich das flüssige Lot in die Öffnung 26 zurück und bildet die Lötverbindung 28 aus. Gemäß einer nicht dargestellten Ausführungsform ist es auch denkbar, dass der Anschlussstift 18 auf einer Rückseite 30 der ersten Leiterplatte 12 verlötet ist.

Ebenfalls wäre es denkbar, dass der Anschlussstift in einem die erste Leiterplatte 12 auf der Rückseite 30 überragenden Abschnitt einen vorgefertigten Setzkopf umfasst, so dass die Nietverbindung durch Umformen des über die zweite Leiterplatte 14 herausragenden Abschnitt 24 geschlossen wird.

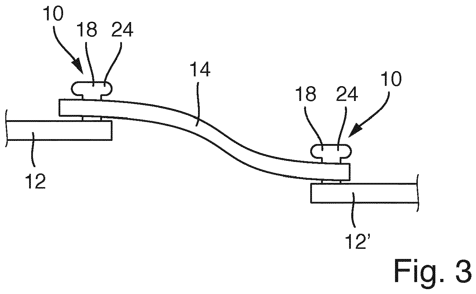

Figur 3 zeigt mehrere mit erfindungsgemäßen Kontaktverbindungen 10 miteinander verbundene Leiterplatten 12, 14 in einer Ansicht von der Seite. Die erste Leiterplatte 12 eine starre Leiterplatte und die zweite Leiterplatte 14 ist eine flexible Leiterplatte. Ferner ist eine weitere, starre Leiterplatte 12' vorgesehen. Die erste Leiterplatte 12 umfasst beispielsweise als nichtleitendes Trägermaterial eine mit Epoxidharz getränkte Glasfasermatte, welches auch unter der Materialkennung FR4 bekannt ist. Die zweite Leiterplatte 14 ist beispielsweise eine, insbesondere dünne, Leiterplatte auf Basis von Polyimid-Folien. Gemäß der dargestellten Ausführungsform ist die zweite Leiterplatte 14 zum Verbinden der zwei starren Leiterplatten 12, 12', vorgesehen. Eine solche Verwendung ist beispielsweise in Beleuchtungseinrichtungen, insbesondere zum Verbinden von LED-Leiterplatten, denkbar. Eine LED-Leiterplatte umfasst dabei eine oder mehrere LEDs, wobei mehrere Leiterplatten insbesondere bei Beleuchtungseinrichtungen mit Mehrkammerreflektoren oder/oder mit mehreren Einspeisepunkten verwendet werden.

## Patentansprüche

1. Elektrisch leitende Kontaktverbindung (10) zwischen einer ersten und einer zweiten Leiterplatte (12, 14), umfassend die erste und die zweite Leiterplatte und einen Anschlussstift (18), wobei die erste Leiterplatte (12) eine starre Leiterplatte und die zweite Leiterplatte (14) eine flexible Leiterplatte ist, wobei die erste Leiterplatte (12) im Bereich der Kontaktverbindung (10) den Anschlussstift (18) umfasst und die zweite Leiterpatte (14) im Bereich der Kontaktverbindung (10) eine Durchstecköffnung (16) umfasst, wobei der Anschlussstift (18) der ersten Leiterplatte (12) wenigstens teilweise aus einem elektrisch leitfähigen Material ausgebildet ist und durch die Durchstecköffnung (16) der zweiten Leiterplatte (14) hindurch gesteckt ist, wobei der Anschlussstift (18) in einem durch die Durchstecköffnung (16) der zweiten Leiterplatte (14) über die zweite Leiterplatte (14) herausragenden Abschnitt (24) durch einen Umformvorgang, insbesondere einen Biegevorgang oder einen Nietvorgang, derart umgeformt ist, dass zwischen der ersten und der zweiten Leiterplatte (12, 14) eine formschlüssige Verbindung ausgebildet ist, **dadurch gekennzeichnet, dass** der Anschlussstift (18) mit der ersten Leiterplatte (12) mittels eines Pin-in-Paste-Lötverfahrens, oder mittels eines SMT-, Surface-Mounting-Technologie, Lötverfahrens, verbunden ist.

2. Kontaktverbindung (10) nach Anspruch 1, **dadurch gekennzeichnet, dass** eine Innenwandung (22) der Durchstecköffnung (16) der zweiten Leiterplatte (14) ein elektrisch leitfähiges Material umfasst.

3. Verfahren zum Herstellen einer elektrisch leitenden Kontaktverbindung (10) zwischen einer ersten Leiterplatte (12) und einer zweiten Leiterplatte (14) umfassend die erste und die zweite Leiterplatte (12, 14) und einen Anschlussstift (18), wobei die erste Leiterplatte (12) eine starre Leiterplatte und die zweite Leiterplatte (14) eine flexible Leiterplatte ist, wobei die erste Leiterplatte (12) im Bereich der Kontaktverbindung (10) den Anschlussstift (18) umfasst und die zweite Leiterplatte (14) im Bereich der Kontaktverbindung (10) eine Durchstecköffnung (16) umfasst, wobei der Anschlussstift (18) der ersten Leiterplatte (12) wenigstens teilweise aus einem elektrisch leitfähigen Material ausgebildet ist, wobei der Anschlussstift (18) der ersten Leiterplatte (12) durch die Durchstecköffnung (16) der zweiten Leiterplatte (14) hindurch gesteckt wird, und anschließend ein durch die Durchstecköffnung (16) der zweiten Leiterplatte (14) über die zweite Leiterplatte (14) herausragender Abschnitt (24) des Anschlussstifts (18) in einem Umformvorgang, insbesondere einem Biegevorgang oder einem Nietvorgang, derart umgeformt wird, dass zwischen der ersten und der zweiten Leiterplatte (12, 14) eine formschlüssige Verbindung ausgebildet wird, **dadurch gekennzeichnet, dass** der Anschlussstift (18) in einem vorhergehenden Schritt mit der ersten Leiterplatte (12) mittels eines Pin-in-Paste Lötverfahrens, oder dass der Anschlussstift (18) in einem vorhergehenden Schritt mit der ersten Leiterplatte (12) mittels eines SMT-, Surface-Mounting-Technologie-, Lötverfahrens, verbunden wird.

## Claims

1. Electrically conductive contact connection (10) between a first and a second circuit board (12, 14), comprising the first and the second circuit board and a connection pin (18), the first circuit board (12) being a rigid circuit board and the second circuit board (14) being a flexible circuit board, the first circuit board (12) comprising the connection pin (18) in the region of the contact connection (10) and the second circuit board (14) comprising an insertion opening (16) in the region of the contact connection (10), the connection pin (18) of the first circuit board (12) being at least partially formed from an electrically conductive material and being inserted through the insertion opening (16) of the second circuit board (14), the connection pin (18) being formed in a portion (24) protruding through the insertion opening (16) of the second circuit board (14) beyond the second circuit board (14) by a forming process, in particular a bending process or a riveting process, in such a way that that a form-fitting connection is formed between the first and the second circuit board (12, 14), **characterized in that** the connection pin (18) is connected to the first circuit board (12) by means of a pin-in-paste soldering process or by means of an SMT (surface mounting technology) soldering process.

2. Contact connection (10) according to claim 1, **characterized in that** an inner wall (22) of the insertion opening (16) of the second circuit board (14) comprises an electrically conductive material.

3. Method for producing an electrically conductive contact connection (10) between a first circuit board (12) and a second circuit board (14), comprising the first and the second circuit board (12, 14) and a connection pin (18), the first circuit board (12) being a rigid circuit board and the second circuit board (14) being a flexible circuit board, the first circuit board (12) comprising the connection pin (18) in the region of the contact connection (10) and the second circuit board (14) comprising an insertion opening (16) in the region of the contact connection (10), the connection pin (18) of the first circuit board (12) being at least partially formed from an electrically conductive material, the connection pin (18) of the first circuit board (12) being inserted through the insertion opening (16) of the second circuit board (14), and then a portion (24) of the connection pin (18) protruding through the insertion opening (16) of the second circuit board (14) beyond the second circuit board (14) being formed in a forming process, in particular a bending process or a riveting process, in such a way that a form-fitting connection is formed between the first and the second circuit board (12, 14), **characterized in that** the connection pin (18) is connected to the first circuit board (12) in a preceding step by means of a pin-in-paste soldering process, or **in that** the connection pin (18) is connected to the first circuit board (12) in a preceding step by means of an SMT (surface mounting technology) soldering process.

## Revendications

1. Connexion à contact (10) électriquement conductrice entre une première et une seconde carte de circuit imprimé (12, 14), comprenant la première et la seconde carte de circuit imprimé et une broche de connexion (18), dans laquelle la première carte de circuit imprimé (12) est une carte de circuit imprimé rigide et la seconde carte de circuit imprimé (14) est une carte de circuit imprimé flexible, dans laquelle la première carte de circuit imprimé (12) comprend la broche de connexion (18) dans la zone de la connexion à contact (10) et la seconde carte de circuit imprimé (14) comprend une ouverture de passage (16) dans la zone de la connexion à contact (10), dans laquelle la broche de connexion (18) de la première carte de circuit imprimé (12) est réalisée au moins partiellement à partir d'un matériau électriquement conducteur et est enfichée à travers l'ouverture de passage (16) de la seconde carte de circuit imprimé (14), dans laquelle la broche de connexion (18) est déformée par un processus de déformation, en particulier un processus de pliage ou un processus de rivetage, dans une section (24) faisant saillie au-dessus de la seconde carte de circuit imprimé (14) à travers l'ouverture de passage (16) de la seconde carte de circuit imprimé (14), de telle sorte qu'une liaison par complémentarité de forme est réalisée entre la première et la seconde carte de circuit imprimé (12, 14), **caractérisée en ce que** la broche de connexion (18) est reliée à la première carte de circuit imprimé (12) au moyen d'un procédé de brasage Pin-in-Paste ou au moyen d'un procédé de brasage SMT, technique de montage en surface.

2. Connexion à contact (10) selon la revendication 1, **caractérisée en ce qu'**une paroi interne (22) de l'ouverture de passage (16) de la seconde carte de circuit imprimé (14) comprend un matériau électriquement conducteur.

3. Procédé de fabrication d'une connexion à contact (10) électriquement conductrice entre une première carte de circuit imprimé (12) et une seconde carte de circuit imprimé (14), comprenant la première et la seconde carte de circuit imprimé (12, 14) et une broche de connexion (18), dans lequel la première carte de circuit imprimé (12) est une carte de circuit imprimé rigide et la seconde carte de circuit imprimé (14) est une carte de circuit imprimé flexible, dans lequel la première carte de circuit imprimé (12) comprend la broche de connexion (18) dans la zone de la connexion à contact (10) et la seconde carte de circuit imprimé (14) comprend une ouverture de passage (16) dans la zone de la connexion à contact (10), dans lequel la broche de connexion (18) de la première carte de circuit imprimé (12) est réalisée au moins partiellement à partir d'un matériau électriquement conducteur, dans lequel la broche de connexion (18) de la première carte de circuit imprimé (12) est enfichée à travers l'ouverture de passage (16) de la seconde carte de circuit imprimé (14), et une section (24) de la broche de connexion (18), laquelle section fait saillie au-dessus de la seconde carte de circuit imprimé (14) à travers l'ouverture de passage (16) de la seconde carte de circuit imprimé (14), est ensuite déformée par un processus de déformation, en particulier un processus de pliage ou un processus de rivetage, de telle sorte qu'une liaison par complémentarité de forme est réalisée entre la première et la seconde carte de circuit imprimé (12, 14), **caractérisé en ce que** la broche de connexion (18) est reliée, dans une étape précédente, à la première carte de circuit imprimé (12) au moyen d'un procédé de brasage Pin-in-Paste, ou **en ce que** la broche de connexion (18) est reliée, dans une étape précédente, à la première carte de circuit imprimé (12) au moyen d'un procédé de brasage SMT, technique de montage en surface.
